# FASCICULE DE BREVET EUROPEEN

(11) **EP 2 974 571 B1**
(45) Date de publication et mention de la délivrance du brevet: **19.09.2018**
(21) Numéro de dépôt: 14713527.1
(22) Date de dépôt: 05.03.2014
(51) Int. Cl.: H05K 7/14, H02M 3/24, H02M 7/00

(54) **CONVERTISSEUR DE PUISSANCE DE COURANT CONTINU EN COURANT CONTINU REVERSIBLE, PROCÉDÉ DE FABRICATION ET UTILISATION CORRESPONDANTS**
UMKEHRBARER DC-DC-WANDLER, SOWIE ENTSPRECHENDES VERFAHREN ZUR HERSTELLUNG UND VERWENDUNG
REVERSIBLE DC-TO-DC POWER CONVERTER, AND CORRESPONDING METHOD OF PRODUCTION AND USE

(30) Priorité: 11.03.2013 FR 1352141
(43) Date de publication de la demande: 20.01.2016
(73) Titulaire: Valeo Equipements Electriques Moteur, 94046 Créteil Cedex (FR)
(72) Inventeur: GUERIN, Fabien, 92320 Chatillon (FR); HOSNI, Alexis, 75018 Paris (FR); RANIER, Marc, 94290 Villeneuve Le Roi (FR); BAUDESSON, Philippe, 27220 La Boissiere (FR); THIMON, Alain, 93230 Romainville (FR)
(74) Mandataire: Cardon, Nicolas
(86) Numéro de dépôt international: PCT/FR2014/050489
(87) Numéro de publication internationale: WO 2014/140452

(56) Documents cités:
- EP-A1- 2 403 323
- EP-A2- 1 696 546
- EP-A2- 2 328 391
- WO-A1-99/62168
- DE-A1- 19 855 076
- US-A1- 2005 083 714

## Description

### DOMAINE TECHNIQUE DE L'INVENTION.

La présente invention concerne un convertisseur de puissance de courant continu en courant continu réversible et son procédé de fabrication. Elle concerne également l'utilisation de ce convertisseur de puissance dans un réseau bitension de véhicule automobile.

### ARRIERE PLAN TECHNOLOGIQUE DE L'INVENTION.

Les véhicules automobiles à moteur thermique comportent classiquement un réseau électrique de bord comprenant une batterie, généralement de 12 V, destiné à alimenter en énergie électrique les divers équipements, notamment un démarreur, indispensable pour assurer le démarrage du moteur thermique. Après le démarrage, un alternateur accouplé au moteur thermique assure la charge de la batterie.

De nos jours, le développement de l'électronique de puissance permet d'alimenter et de piloter une seule machine électrique tournante polyphasée réversible qui remplace avantageusement le démarreur et l'alternateur.

Dans un premier temps, cette machine, connue sous le nom d'alterno-démarreur, avait essentiellement pour but de remplir les fonctions autrefois dédiées à l'alternateur et au démarreur, et, accessoirement, de récupérer l'énergie au freinage, ou d'apporter un supplément de puissance et de couple au moteur thermique.

Dans le but d'accroître la puissance et d'améliorer le rendement de l'alterno-démarreur en augmentant sa tension de fonctionnement tout en conservant la possibilité d'utiliser des autres équipements standards, prévus pour une alimentation de 12 V à 14 V, notamment les batteries au plomb, a été développée une architecture dite "14 + X", ou "micro-hybride".

Cette architecture consiste donc en un réseau électrique de puissance reliant l'alterno-démarreur à un élément de stockage d'énergie électrique fonctionnant à une tension supérieure à 14 V, pouvant atteindre 48 V, et en un réseau électrique de service reliant tous les autres équipements. L'adaptation des niveaux de tensions entre les deux réseaux est assurée par un convertisseur continu/ continu réversible.

Un tel convertisseur continu/ continu réversible est par exemple décrit dans la demande brevet FR2833113 de la société VALEO EQUIPEMENTS ELECTRIQUES MOTEUR.

Les documents "DE 198 55 076 A1", "WO 99/62168 A1" et "US 2005/083714 A1" montrent chacun des convertisseurs de puissance de courant continu en courant continu réversible.

Dans un second temps, des considérations écologiques, ont conduit à concevoir des alterno-démarreurs ayant une puissance, de l'ordre de 8 à 10 KW, suffisante pour entraîner le véhicule à faible vitesse, par exemple en environnement urbain.

De telles puissances n'ont pu être obtenues tout en conservant des machines électriques compactes qu'en portant la tension du réseau électrique de puissance à une tension, de l'ordre de 60 V, bien supérieure à la tension nominale des batteries au plomb classiques.

Par ailleurs, des réseaux de puissance à des tensions allant jusqu'à 120V peuvent être mis en oeuvre dans une architecture qui permet au véhicule d'être entraîné à pleine vitesse par le moteur électrique (architecture dite "full-hybrid" en terminologie anglaise, par comparaison à l'architecture précédente dite "mild-hybrid").

Compte tenu des niveaux de puissance requis, les convertisseurs utilisés dans ces applications ne sont plus réalisés sous forme de modules intégrant des composants électroniques sur des circuits imprimés en époxy (de type FR4), mais font appel à la technologie des substrats métalliques isolés (SMI) qui permet une meilleure dissipation thermique.

Cette technologie, qui est en soi bien connue pour la réalisation de modules électroniques avec des composants montés en surface (CMS) classiques, a été adaptée par la société VALEO ELECTRONIQUE au montage de connecteurs, selon le procédé original décrit dans la demande de brevet FR2721161.

Les éléments de stockage d'énergie électrique - selfs ou condensateurs - mis en oeuvre dans des convertisseurs de puissance sont des composants dits "traversants".

Comme l'étaient les connecteurs, ces composants traversants sont difficiles à soudés sur un SMI en termes de process et ne sont pas actuellement intégrés sur un SMI comme sur un FR4, car cela conduirait à des risques de court-circuit.

En effet, un perçage dans le SMI de dimension légèrement supérieure à celle de la broche du composant serait nécessaire pour permettre la soudure, mais cette broche pourrait entrer en contact avec le substrat en aluminium et la soudure pourrait également migrer par capillarité au-delà de la couche isolante.

Ces selfs et/ ou condensateurs des convertisseurs de puissance connus de l'état de la technique sont donc placés à côté du SMI et reliés aux pistes de celui-ci par des traces de liaison (formées dans de la tôle de cuivre découpée) surmoulées dans une pièce intermédiaire.

Dans certains cas, selon le routage du SMI, cela impose d'avoir des traces de liaison longues, ce qui implique un surcoût (quantité de cuivre) et crée une source de chaleur supplémentaire (auto-échauffement).

De plus, la pièce intermédiaire extérieure au SMI est un élément qui doit être spécifique à chaque couple de tension d'entrée/ tension de sortie du convertisseur et qui ne peut pas être standardisée pour permettre des économies d'échelle dans une gamme de convertisseurs de puissance telle que 12 V/ 24 V/ 48 V/ 60 V/ 120 V par exemple.

Il existe donc un besoin pour un convertisseur de puissance palliant les inconvénients mentionnés ci-dessus.

### DESCRIPTION GENERALE DE L'INVENTION.

La présente invention vise à répondre à ce besoin avec un convertisseur de puissance de courant continu en courant continu réversible fonctionnant entre une première tension continue et une seconde tension continue, comprenant des composants électroniques de type CMS montés sur un substrat métallique isolé et des éléments électroniques de type "traversants" comportant des broches de connexion ou des languettes de connexion.

Les composants électroniques comprennent notamment des éléments de commutation et les éléments électroniques comprennent principalement des selfs et/ ou des condensateurs.

Ce convertisseur de puissance CC/CC réversible est remarquable en ce que des premiers semi-conducteurs parmi les éléments de commutation commutant la première tension sont disposés sur une première partie latérale du SMI et forment un premier module, des seconds semi-conducteurs parmi les éléments de commutation commutant la seconde tension sont disposés sur une seconde partie latérale du SMI et forment un second module, et en ce que les éléments électroniques sont disposés sous une partie médiane du SMI, entre les première et seconde parties latérales, formant un module intermédiaire.

Le module intermédiaire est fort avantageusement standard dans une gamme de plusieurs exemplaires de ce convertisseur de puissance et, de préférence, les premier et second modules sont adaptés aux première et seconde tensions continues choisies parmi un ensemble de tensions nominales comprenant: 12 V, 24 V, 48 V, 60 V et 120 V.

Dans le convertisseur de puissance CC/CC réversible selon l'invention, chacun des éléments électroniques de type "traversants" est soudé sur le SMI au moyen d'un chapeau de soudure engagé par une ouverture sur au moins une des broches de connexion ou des languettes de connexion.

De préférence, ce chapeau de soudure est de forme sensiblement parallélépipédique.

Avantageusement, il comporte une partie inférieure présentant une bride s'étendant dans le plan du SMI.

Avantageusement également, il comporte une paroi présentant au moins un pli.

On tirera aussi bénéfice du fait que ce chapeau de soudure comporte si besoin une partie supérieure présentant une collerette.

L'invention concerne également un procédé de fabrication d'un convertisseur de puissance de courant continu en courant continu réversible comprenant des composants électroniques de type CMS montés sur un substrat métallique isolé et des éléments électroniques de type "traversants" comportant des broches de connexion.

Ce procédé de fabrication apte à la fabrication du convertisseur de puissance décrit ci-dessus est remarquable en ce que:
- on réalise dans le SMI des trous débouchants en des emplacements prévus pour recevoir les broches de connexion;
- on soude par refusion les composants électroniques de type CMS sur le SMI et des chapeaux de soudure en regard des trous débouchants;
- on place les éléments électroniques sous le SMI en engageant les broches de connexion dans les trous débouchants et les chapeaux de soudure;
- on réalise une soudure à la vague sélective des chapeaux de soudure et des broches de connexion.

Alternativement, dans le cas où les éléments électroniques de type "traversants" comportent des languettes de connexion ou des broches de connexion présentant une extrémité bombée, le procédé de fabrication selon l'invention apte à la fabrication de ce convertisseur de puissance est modifié comme suit:
- on réalise dans le SMI des boutonnières ou des trous débouchants en des emplacements prévus pour recevoir les languettes ou les broches de connexion;
- on soude par refusion les composants électroniques de type CMS sur le SMI et des chapeaux de soudure présentant des collerettes supérieures en regard de ces boutonnières ou de ces trous débouchants;
- on place les éléments électroniques sous le SMI en engageant les languettes ou les broches de connexion dans les boutonnières ou les trous débouchants et les chapeaux de soudure;
- on réalise une soudure électrique ou une soudure au laser des collerettes et des languettes ou des broches de connexion.

Il va de soi que l'on tirera bénéfice de l'utilisation d'un convertisseur de puissance CC/CC réversible selon l'invention dans un réseau bitension de véhicule automobile.

Ces quelques spécifications essentielles auront rendu évidents pour l'homme de métier les avantages apportés par ce convertisseur de puissance CC/CC réversible par rapport à l'état de la technique antérieur.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** montre schématiquement l'implantation de composants électroniques de type CMS et d'éléments électroniques de type "traversants" dans un convertisseur de puissance CC/CC réversible connu de l'état de la technique.
La **Figure 2** montre schématiquement l'implantation de composants électroniques de type CMS et d'éléments électroniques de type "traversants" dans un convertisseur de puissance CC/CC réversible selon l'invention.
Les **Figures 3a, 3b et 3c** montrent de manière détaillée trois exemples d'implantation d'éléments électroniques de type "traversants" dans un convertisseur de puissance CC/CC réversible selon l'invention.
La **Figure 4** est une vue de profil schématique d'un convertisseur de puissance CC/CC réversible selon l'invention.
La **Figure 5** montre en perspective un chapeau de soudure du type utilisé pour souder les éléments électroniques de type "traversants" dans un convertisseur de puissance CC/CC réversible selon l'invention.
La **Figure 6a** montre une variante du chapeau de soudure montré sur la **Figure 5** réalisée par pliage de l'ébauche montrée sur la **Figure 6b****.**
La **Figure 7** illustre l'impossibilité d'une soudure d'un élément électronique de type "traversant" sur un SIM par un procédé de soudure classique.
Les **Figures 8a et 8b** illustrent le procédé de fabrication d'un convertisseur de puissance CC/CC réversible selon l'invention utilisant, respectivement, le chapeau de soudure montré sur la **Figure 5** ou le chapeau de soudure montré sur

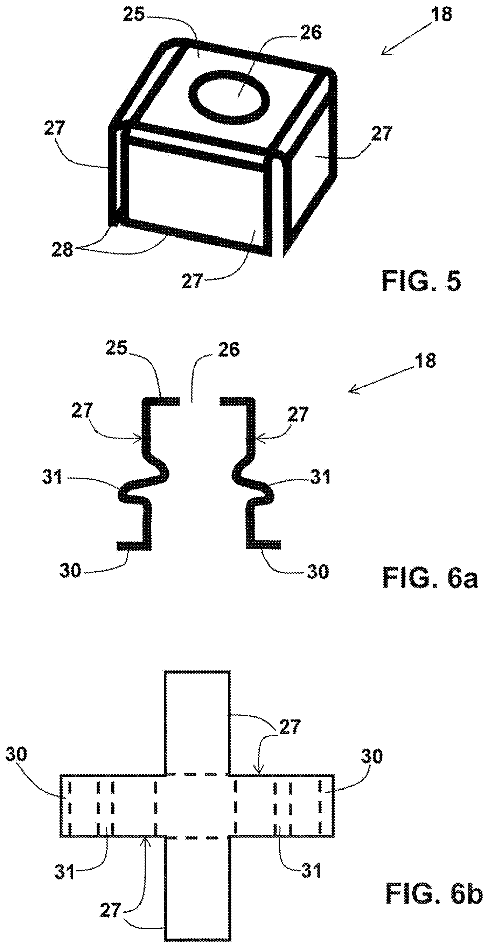

### la Figure 6a.

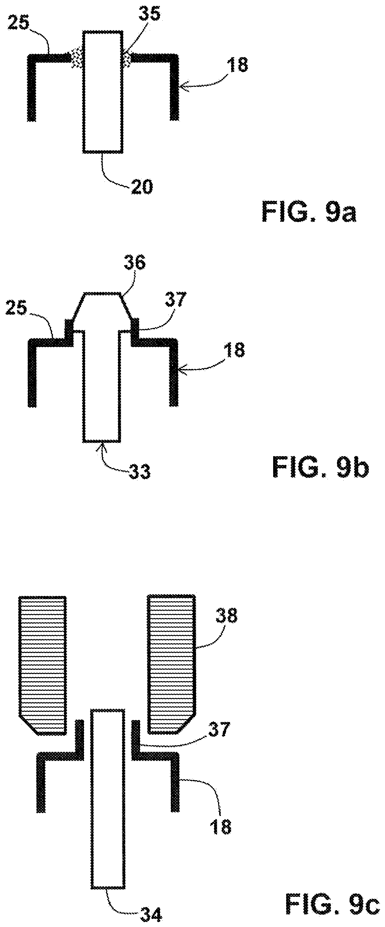

Les **Figures 9a, 9b et 9c** illustrent le procédé de fabrication d'un convertisseur de puissance CC/CC réversible selon l'invention mettant en oeuvre, respectivement, une soudure à la vague sélective avec le chapeau de soudure montré sur la **Figure 5 ou 6a****,** une soudure au laser ou une soudure électrique avec une variante à collerette du chapeau de soudure.

### DESCRIPTION DES MODES DE REALISATION PREFERES DE L'INVENTION.

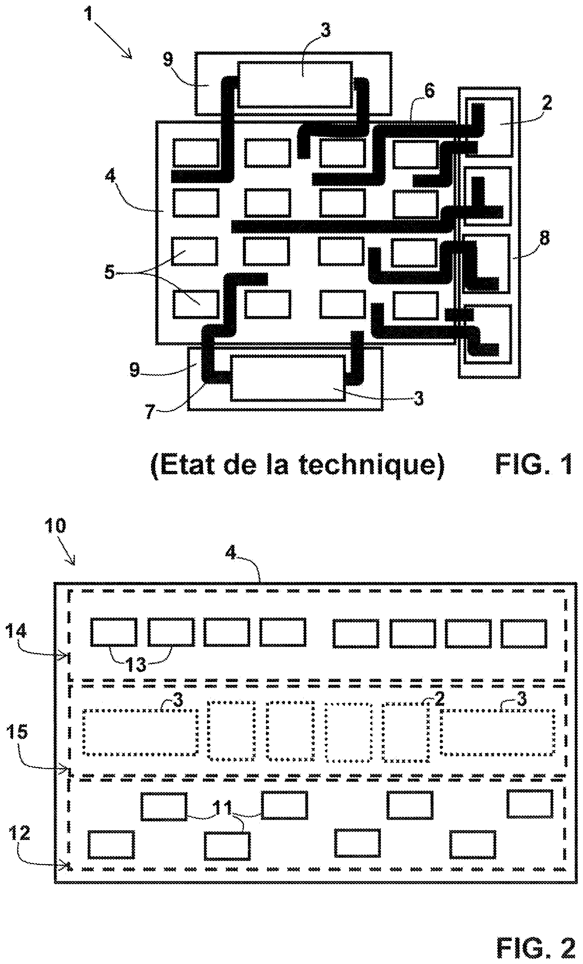

Dans l'exemple de convertisseur de puissance CC/CC réversible 1 connu de l'état de la technique montré sur la **Figure 1****,** les éléments électroniques 2, 3 de type "traversants", tels que des selfs 2, des condensateurs électrolytiques ou à film diélectrique 3, sont placés à coté du SMI 4 de forme rectangulaire qui supporte les composants électroniques 5 de type CMS, notamment des éléments de commutation.

Ces éléments électroniques 2, 3 volumineux sont reliés aux pistes du SMI 4 par des traces de liaison 6, 7 surmoulées dans des pièces intermédiaires 8, 9 en matériau isolant.

Afin de réduire la longueur des liaisons électriques entre les éléments électroniques 2, 3 et le SMI 4, et pallier les inconvénients de l'implémentation montrée sur la **Figure 1****,** les éléments électroniques 2, 3 sont soudés sur le SMI 4 comme le montre la **Figure 2****.**

L'intégration des selfs 2 et des condensateurs 3 de type "traversants" sur le SMI 4 permet une conception modulaire du convertisseur de puissance CC/CC réversible 10 selon l'invention, afin de répondre aux spécifications de différents réseaux bitension de véhicules automobiles tout en bénéficiant d'économies d'échelle.

Des premiers semi-conducteurs 11 de type MOSFET sont montés en surface sur une première partie latérale 12 du SMI 4 selon un schéma connu en soi de hacheur ou de redresseur d'une première tension de fonctionnement du convertisseur 10, par exemple une tension nominale de 12 V correspondant à la partie du réseau de bord comprenant une batterie au plomb classique.

Des seconds semi-conducteurs 13 de type MOSFET sont montés en surface sur une seconde partie latérale 14 du SMI 4 selon un autre schéma également connu en soi de hacheur ou de redresseur d'une seconde tension de fonctionnement du convertisseur 10, par exemple une autre tension nominale de 24 V, 48 V, 60 V ou 120 V correspondant à la partie du réseau de bord comprenant des stockeurs d'énergie de hautes performances, le moteur de propulsion ou d'autres équipements de puissance.

Les selfs 2 et/ ou les condensateurs 3, assurant le stockage transitoire de l'énergie électrique sous la première tension pour la restituer sous la seconde tension de manière connue, sont disposés dans une partie médiane 15 du SMI 4, entre les première et seconde parties latérales 12, 14.

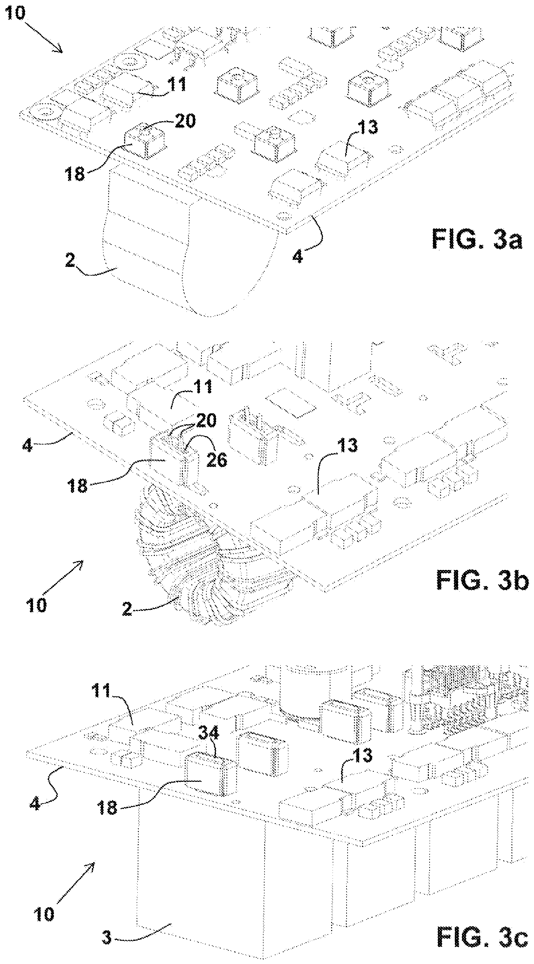

Comme le montrent bien les **Figures 3a, 3b et 3c****,** ces éléments électroniques 2, 3 de type "traversants" sont disposés sous le SMI 4, c'est-à-dire du coté opposé aux pistes du SMI 4 sur lesquelles sont soudés les composants électroniques 5, 11, 13 de type CMS.

Pour satisfaire au besoin de refroidissement des éléments de commutation 5, 11, 13, le SMI 4 est généralement fixé de manière connue sur un radiateur 16.

Dans le convertisseur de puissance CC/CC réversible 10 selon l'invention, les premiers et seconds semi-conducteurs 11, 13 étant placés dans les première et seconde parties latérales 12, 14 du SMI 4, le radiateur 16 ne comporte des ailettes 17 que sous ces première et seconde parties latérales 12, 14, laissant libre un espace situé sous la partie médiane 15 du SMI 4.

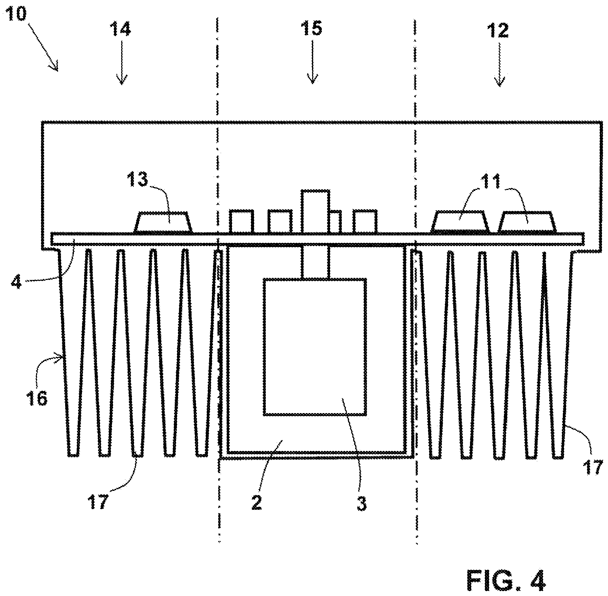

Cet espace est occupé par les selfs 2 et/ ou les condensateurs 3, comme le montre bien la **Figure 4****,** ce qui fait que, en termes d'implantation, l'agencement des éléments électroniques 2, 3 sous le SMI 4 n'augmente pas le volume global du convertisseur 10 dans la mesure où la hauteur des éléments électroniques 2, 3 est compatible avec celle des ailettes 17 du radiateur 16.

On ne peut pas souder les éléments électroniques 2, 3 de type "traversants" directement sur le SMI 4 de la même manière que sur un circuit imprimé en époxy de type FR4, mais au moyen d'un chapeau de soudure 18 dont plusieurs modèles différents sont montrés schématiquement sur les **Figures 5, 6a****,** **9a ou 9b**.

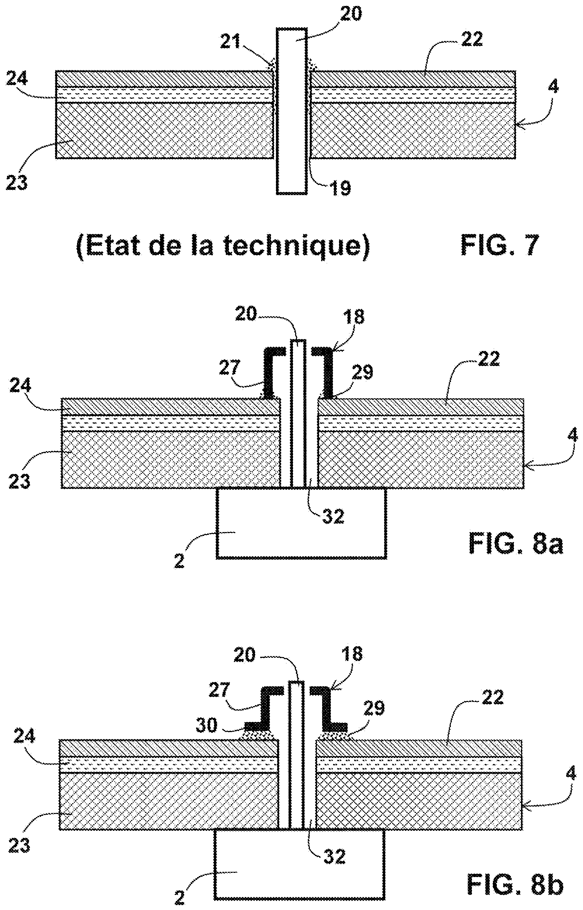

En effet, comme cela a déjà été indiqué en préambule et comme le montre bien la **Figure 7****,** un perçage 19 dans le SMI 4 de dimension légèrement supérieure à celle de la broche 20 du composant serait nécessaire pour permettre la soudure 21 sur la piste en cuivre 22, mais cette broche 20 pourrait entrer en contact avec le substrat en aluminium 23 du SMI 4 et la soudure 21 pourrait également migrer par capillarité au-delà de la couche isolante 24.

Un chapeau de soudure 18 sert donc d'interface entre le SMI 4 et l'élément électronique 2, 3 de type "traversant" à souder.

Ce chapeau de soudure 18 est de la forme générale d'un parallélépipède comme le montre la **Figure 5****.**

Il comprend une face supérieure 25 présentant une ouverture 26 destinée à recevoir un élément de connexion 20, broche ou languette, et quatre parois 27 adjacentes dont les bords inférieurs 28 sont destinés à être soudés sur la piste 22 du SMI 4 comme le montre schématiquement la **Figure 8a**.

Le chapeau de soudure 18 est soudé sur le SMI 4 de la même manière qu'un composant électronique 5, 11, 13 de type CMS, c'est-à-dire qu'il est déposé sur le SMI 4, pourvu de pâte à braser après sérigraphie, par une machine de type "pick'n place", et qu'il est ensuite passé dans un four de refusion pour former une brasure 29 entre les bords inférieurs 28 et la piste 22.

Des formes spécifiques sont définies pour faciliter le brasage du chapeau de soudure 18 sur le SMI 4, tel qu'un rajout d'une bride 30 sur une partie inférieure du chapeau de soudure 18, comme le montre bien la **Figure 6a****,** afin d'augmenter la surface mouillée par la brasure 29 comme le montre la **Figure 8b**.

Des zones de souplesse 31, formées par au moins un pli dans les parois 27, permettent aussi avantageusement une dilatation différentielle des éléments de connexion 20 des éléments électroniques 2, 3.

Un chapeau de soudure 18, de forme générale simple, parallélépipédique ou cubique, est réalisé facilement par pliage d'une ébauche, obtenue par poinçonnage d'une tôle métallique, telle que celle montrée schématiquement sur la **Figure 6b**.

De cette façon, la bride 30 et les zones de souplesse 31 sont aussi facilement réalisées.

Les chapeaux de soudure 18 ayant été soudés sur le SMI 4 en regard de trous débouchants 32 ou de boutonnières réalisés dans le SMI 4 aux emplacements prévus pour recevoir les éléments électroniques 2,3 de type "traversants", ces éléments électroniques 2, 3 sont mis en place sous le SMI en engageant leurs éléments de connexion 20, 33, 34 dans ces trous débouchants 32 ou ces boutonnières, et dans l'ouverture 26 des chapeaux de soudure 18.

Comme le montrent bien les **Figures 8a et 8b****,** la largeur de ces trous débouchants 32 est largement supérieure au diamètre de la broche de connexion 20 pour éviter tout risque de court-circuit entre la broche de connexion 20 et le substrat 23 du SMI 4 (il en est de même pour des boutonnières relativement aux languettes de connexion 34).

Pour l'interfaçage avec l'élément électronique 2, 3 à souder, la partie supérieure 25 du chapeau de soudure 18 se présente sous différentes formes selon le procédé de soudure mis en oeuvre et selon qu'il s'agit de souder une broche de connexion simple 20, une broche à l'extrémité bombée 33, ou languette de connexion 34.

S'il s'agit d'une broche de connexion simple 20, cylindrique ou carrée, la brasure 35 est formée entre une périphérie de l'ouverture 26 du chapeau de soudure 18 et l'extrémité de la broche de connexion 20, comme le montre la **Figure 9a****,** par une soudure à la vague sélective du SMI 4 retourné.

S'il s'agit d'une broche de connexion 33 présentant une extrémité bombée 36, comme le montre la **Figure 9b****,** la soudure est alternativement une soudure au laser de l'extrémité bombée 36 sur une collerette 37 que présente la partie supérieure d'une variante du chapeau de soudure 18.

Dans le cas d'une languette de connexion 34, une variante de ce type présentant une collerette 37 autour d'une ouverture allongée 26 du chapeau de soudure 18 est utilisée.

Comme le représente la **Figure 9c****,** on réalise avantageusement la soudure au moyen d'une soudeuse électrique dont la pince 38 est appliquée sur la collerette 37.

Les **Figures 3a, 3b et 3c** montrent bien l'agencement des chapeaux de soudure 18 sur le SMI 4 pour différents types d'éléments de connexion 20, 34 dans trois exemples de réalisation du convertisseur de puissance 10 selon l'invention.

Sur la **Figure 3a****,** une self 2 comporte des broches de connexion simples 20; elle est soudée sur le SMI 4 au moyen du chapeau de soudure 18 cubique du type montré sur la **Figure 5** ou la **Figure 8a**.

Sur la **Figure 3b****,** une self 2 comporte des éléments de connexion constitués par les extrémités double des enroulements; un chapeau de soudure 18 parallélépipédique également du type montré sur la **Figure 5** ou la **Figure 8a****,** et comportant une ouverture 26 allongée, est utilisé.

Sur la **Figure 3c****,** un condensateur 3 comporte des languettes de connexion 34; comme précédemment, un chapeau de soudure 18 parallélépipédique du type montré sur la **Figure 5** ou la **Figure 8a****,** et comportant une ouverture 26 allongée, est utilisé.

Comme il va de soi, l'invention ne se limite pas aux seuls modes d'exécution préférentiels décrits ci-dessus.

Notamment, les formes et les caractéristiques distinctives des chapeaux de soudure 18 spécifiées, ou représentées, ne sont que des exemples de réalisation adaptés à des éléments de connexion (20, 33, 34) particuliers.

Les types de semi-conducteurs 11, 13 indiqués ne sont pas non plus limitatifs: d'autres éléments de commutation 11, 13 de type CMS sont alternativement mis en oeuvre.

Des éléments électroniques 2, 3 de type "traversants" autres que des selfs 2 ou des condensateurs 3, par exemple des connecteurs, sont intégrés avantageusement sur le SMI 4 au moyen de chapeaux de soudure 18 appropriés par le procédé décrit ci-dessus autant que de besoin.

Enfin, la gamme des tensions de fonctionnement indiquée correspond à des standards actuels qui sont susceptibles d'évoluer.

L'invention embrasse donc toutes les variantes possibles de réalisation dans la mesure où ces variantes restent dans le cadre défini par les revendications ci-après.

## Revendications

1. Convertisseur de puissance de courant continu en courant continu réversible (1, 10) fonctionnant entre une première tension continue et une seconde tension continue, comprenant des composants électroniques (5, 11, 13) de type CMS montés sur un substrat métallique isolé (4) et des éléments électroniques (2, 3) de type "traversants" comportant des broches de connexion (20, 33) ou des languettes de connexion (34), lesdits composants électroniques (2, 3) comprenant des éléments de commutation (5, 11, 13) et lesdits éléments électroniques (2, 3) comprenant des selfs (2) et/ ou des condensateurs (3), **caractérisé en ce que** des premiers semi-conducteurs (11) parmi lesdits éléments de commutation (5, 11, 13) commutant ladite première tension sont disposés sur une première partie latérale (12) dudit substrat métallique isolé (4) formant un premier module, des seconds semi-conducteurs (13) parmi lesdits éléments de commutation (5, 11, 13) commutant ladite seconde tension sont disposés sur une seconde partie latérale (14) dudit substrat métallique isolé (4) formant un second module, lesdits éléments électroniques (2, 3) sont disposés sous une partie médiane (15) dudit substrat métallique isolé (4), entre lesdites première et seconde parties latérales (12, 14), formant un module intermédiaire, et **en ce que** chacun desdits éléments électroniques (2, 3) est soudé sur ledit substrat métallique isolé (4) au moyen d'un chapeau de soudure (18) engagé par une ouverture (26) sur au moins une desdites broches de connexion (20, 33) ou desdites languettes de connexion (34).

2. Convertisseur de puissance de courant continu en courant continu réversible (10) selon la revendication 1, **caractérisé en ce que** lesdits premier et second modules (12, 14) sont adaptés auxdites première et seconde tensions continues choisies parmi un ensemble de tensions nominales comprenant: 12 V, 24 V, 48 V, 60 V et 120 V.

3. Convertisseur de puissance de courant continu en courant continu réversible (10) selon la revendication 1 ou la revendication 2, **caractérisé en ce que** ledit chapeau de soudure (18) est de forme sensiblement parallélépipédique.

4. Convertisseur de puissance de courant continu en courant continu réversible (10) selon la revendication 1 ou la revendication 2, **caractérisé en ce que** ledit chapeau de soudure (18) comporte une partie inférieure (28) présentant une bride (30) s'étendant dans le plan dudit substrat métallique isolé (4).

5. Convertisseur de puissance de courant continu en courant continu réversible (10) selon la revendication 1 ou la revendication 2, **caractérisé en ce que** ledit chapeau de soudure (18) comporte une paroi (27) présentant au moins un pli (31).

6. Convertisseur de puissance de courant continu en courant continu réversible (10) selon la revendication 1 ou la revendication 2, **caractérisé en ce que** ledit chapeau de soudure (18) comporte une partie supérieure (25) présentant une collerette (37).

7. Procédé de fabrication d'un convertisseur de puissance de courant continu en courant continu réversible (1, 10) comprenant des composants électroniques (5, 11, 13) de type CMS montés sur un substrat métallique isolé (4) et des éléments électroniques (2, 3) de type "traversants" comportant des broches de connexion (20), ledit procédé de fabrication étant apte à la fabrication d'un convertisseur de puissance (10) selon l'une quelconque des revendications 1 à 5 précédentes, **caractérisé en ce que**:
- on réalise dans ledit substrat métallique isolé (4) des trous débouchants (32) en des emplacements prévus pour recevoir lesdites broches de connexion (20);
- on soude par refusion lesdits composants électroniques (11, 13) de type CMS sur ledit substrat métallique isolé (4) et des chapeaux de soudure (18) en regard desdits trous débouchants (32);
- on place lesdits éléments électroniques (2, 3) sous ledit substrat métallique isolé (4) en engageant lesdites broches de connexion (20) dans lesdits trous débouchants (32) et lesdits chapeaux de soudure (18);
- on réalise une soudure à la vague sélective desdits chapeaux de soudure (18) et desdites broches de connexion (20).

8. Procédé de fabrication d'un convertisseur de puissance de courant continu en courant continu réversible (1, 10) comprenant des composants électroniques (5, 11, 13) de type CMS montés sur un substrat métallique isolé (4) et des éléments électroniques (2, 3) de type "traversants" comportant des languettes de connexion (34) ou des broches de connexion (33) présentant une extrémité bombée (36), ledit procédé de fabrication étant apte à la fabrication d'un convertisseur de puissance (10) selon l'une quelconque des revendications 1 à 6 précédentes, **caractérisé en ce que**:
- on réalise dans ledit substrat métallique isolé (4) des boutonnières ou des trous débouchants (32) en des emplacements prévus pour recevoir lesdites languettes de connexion (34) ou lesdites broches de connexion (33);
- on soude par refusion lesdits composants électroniques (11, 13) de type CMS sur ledit substrat métallique isolé (4) et des chapeaux de soudure (18) présentant des collerettes supérieures (37) en regard desdites boutonnières ou desdits trous débouchants (32);
- on place lesdits éléments électroniques (2, 3) sous ledit substrat métallique isolé (4) en engageant lesdites languettes de connexion (34) ou lesdites broches de connexion (33) dans lesdites boutonnières ou lesdits trous débouchants (32) et lesdits chapeaux de soudure (18);
- on réalise une soudure électrique ou une soudure au laser desdites collerettes (34) et desdites languettes de connexion (34) ou desdites broches de connexion (33).

9. Utilisation d'un convertisseur de puissance de courant continu en courant continu réversible (10) selon l'une quelconque des revendications 1 à 6 précédentes dans un réseau bitension de véhicule automobile.

## Patentansprüche

1. Umkehrbarer Leistungswandler für Gleichstrom in Gleichstrom (1, 10), der zwischen einer ersten Gleichspannung und einer zweiten Gleichspannung funktioniert, der elektronische Bauteile (5, 11, 13) vom Typ CMS umfasst, die auf ein isoliertes metallisches Substrat (4) montiert sind, und elektronische Elemente (2, 3) vom "durchgehenden" Typ, die Verbindungsstifte (20, 33) oder Verbindungslaschen (34) umfassen, wobei die elektronischen Bauteile (2, 3) Umschaltelemente (5, 11, 13) umfassen, und die elektronischen Elemente (2, 3) Induktionsspulen (2) und/oder Kondensatoren (3) umfassen, **dadurch gekennzeichnet, dass** die ersten Halbleiter (11) unter den Umschaltelementen (5, 11, 13), die die erste Spannung umschalten, auf einem ersten seitlichen Teil (12) des isolierten metallischen Substrats (4) angeordnet sind, indem ein erstes Modul gebildet wird, zweite Halbleiterelemente (13) unter den Umschaltelementen (5, 11, 13), die die zweite Spannung umschalten, auf einem zweiten seitlichen Teil (14) des isolierten metallischen Substrats (4) angeordnet sind, indem ein zweites Modul gebildet wird, wobei die elektronischen Elemente (2, 3) unter einem mittleren Teil (15) des isolierten metallischen Substrats (4) zwischen dem ersten und dem zweiten seitlichen Teil (12, 14) angeordnet sind, indem ein Zwischenmodul gebildet wird, und dass jedes der elektronischen Elemente (2, 3) auf das isolierte metallische Substrat (4) mittels einer Schweißraupe (18) geschweißt ist, die durch eine Öffnung (26) auf mindestens einem der Verbindungsstifte (20, 33) oder der Verbindungslaschen (34) eingefügt wird.

2. Umkehrbarer Leistungswandler für Gleichstrom in Gleichstrom (10) nach Anspruch 1, **dadurch gekennzeichnet, dass** das erste und zweite Modul (12, 14) an die die erste und zweite Gleichspannung angepasst sind, die aus einer Einheit von Nennspannungen ausgewählt sind, die Folgende umfassen: 12 V, 24 V, 48 V, 60 V und 120 V.

3. Umkehrbarer Leistungswandler für Gleichstrom in Gleichstrom (10) nach Anspruch 1 oder Anspruch 2, **dadurch gekennzeichnet, dass** die Schweißhaube (18) im Wesentlichen parallelepipedische Form hat.

4. Umkehrbarer Leistungswandler für Gleichstrom in Gleichstrom (10) nach Anspruch 1 oder Anspruch 2, **dadurch gekennzeichnet, dass** die Schweißhaube (18) einen unteren Teil (28) umfasst, der einen Flansch (30) umfasst, der sich in der Ebene des isolierten metallischen Substrats (4) erstreckt.

5. Umkehrbarer Leistungswandler für Gleichstrom in Gleichstrom (10) nach Anspruch 1 oder Anspruch 2, **dadurch gekennzeichnet, dass** die Schweißhaube (18) eine Wand (27), die mindestens eine Falte (31) aufweist, umfasst.

6. Umkehrbarer Leistungswandler für Gleichstrom in Gleichstrom (10) nach Anspruch 1 oder Anspruch 2, **dadurch gekennzeichnet, dass** die Schweißhaube (18) einen oberen Teil (25), der einen Bund (37) aufweist, umfasst.

7. Verfahren zum Herstellen eines umkehrbaren Leistungswandlers für Gleichstrom in Gleichstrom (1, 10), der elektronische Bauteile (5, 11, 13) vom Typ CMS umfasst, die auf ein isoliertes metallisches Substrat (4) montiert sind, und elektronische Elemente (2, 3) vom "durchgehenden" Typ, die Verbindungsstifte (20) umfassen, wobei das Herstellungsverfahren für das Herstellen eines Leistungswandlers (10) nach einem der vorhergehenden Ansprüche 1 bis 5 geeignet ist, **dadurch gekennzeichnet, dass**:
- in dem isolierten metallischen Substrat (4) durchgehende Löcher (32) an Stellen hergestellt werden, die vorgesehen sind, um die Verbindungsstifte (20) aufzunehmen;
- durch Wiederaufschmelzen die elektronischen Bauteile (11, 13) vom Typ CMS auf das isolierte metallische Substrat (4) und Schweißhauben (18) gegenüber den durchgehenden Löchern (32) geschweißt werden;
- die elektronischen Elemente (2, 3) unter dem isolierten metallischen Substrat (4) platziert werden, indem die Verbindungsstifte (20) in die durchgehenden Löcher (32) und die Schweißhauben (18) eingefügt werden;
- ein Wellen-Selektivlötverfahren der Schweißhauben (18) und der Verbindungsstifte (20) ausgeführt wird.

8. Verfahren zum Herstellen eines umkehrbaren Leistungswandlers für Gleichstrom in Gleichstrom (1, 10), der elektronische Bauteile (5, 11, 13) vom Typ CMS umfasst, die auf ein isoliertes metallisches Substrat (4) montiert sind, und elektronische Elemente (2, 3) vom "durchgehenden" Typ, die Verbindungslaschen (34) oder Verbindungsstifte (33) umfassen, die ein gewölbtes Ende (36) aufweisen, wobei das Herstellungsverfahren für die Herstellung eines Leistungsumwandlers (10) nach einem der vorhergehenden Ansprüche 1 bis 6 geeignet ist, **dadurch gekennzeichnet, dass**:
- in dem isolierten metallischen Substrat (4) längliche Aussparungen oder durchgehende Löcher (32) an Stellen hergestellt werden, die vorgesehen sind, um die Verbindungslaschen (34) oder die Verbindungsstifte (33) aufzunehmen;
- die elektronischen Bauteile (11, 13) vom Typ CMS auf dem isolierten metallischen Substrat (4) und Schweißhauben (18), die oberen Bünde (37) gegenüber den länglichen Aussparungen oder den durchgehenden Löchern (32) aufweisen, durch Wiederumschmelzen geschweißt werden;
- die elektronischen Elemente (2, 3) unter dem isolierten metallischen Substrat (4) platziert werden, indem die Verbindungslaschen (34) oder die Verbindungsstifte (33) in die länglichen Aussparungen oder durchgehenden Löcher (32) und die Schweißhauben (18) eingefügt werden;
- eine elektrische Schweißung oder eine Laserschweißung der Bünde (34) und der Verbindungslaschen (34) oder der Verbindungsstifte (33) hergestellt wird.

9. Einsatz eines umkehrbaren Leistungswandlers für Gleichstrom in Gleichstrom (10) nach einem der vorhergehenden Ansprüche 1 bis 6, in einem Kraftfahrzeug-Doppelspannungsnetz.

## Claims

1. Reversible DC-to-DC power converter (1, 10) operating between a first DC voltage and a second DC voltage, comprising SMC electronic components (5, 11, 13) that are mounted on an insulated metal substrate (4) and through-hole electronic elements (2, 3) including connection pins (20, 33) or connection lugs (34), said electronic components (2, 3) comprising switching elements (5, 11, 13) and said electronic elements (2, 3) comprising inductors (2) and/or capacitors (3), **characterized in that** first semiconductors (11) from said switching elements (5, 11, 13) switching said first voltage are positioned on a first lateral portion (12) of said insulated metal substrate (4) forming a first module, second semiconductors (13) from said switching elements (5, 11, 13) switching said second voltage are positioned on a second lateral portion (14) of said insulated metal substrate (4) forming a second module, said electronic elements (2, 3) are positioned under a median portion (15) of said insulated metal substrate (4), between said first and second lateral portions (12, 14), forming an intermediate module, and **in that** each of said electronic elements (2, 3) is soldered to said insulated metal substrate (4) by means of a solder cap (18) that is placed, via an opening (26), over at least one of said connection pins (20, 33) or of said connection lugs (34).

2. Reversible DC-to-DC power converter (10) according to Claim 1, **characterized in that** said first and second modules (12, 14) are suitable for said first and second DC voltages chosen from a set of nominal voltages comprising: 12 V, 24 V, 48 V, 60 V and 120 V.

3. Reversible DC-to-DC power converter (10) according to Claim 1 or Claim 2, **characterized in that** said solder cap (18) is substantially parallelepipedal in shape.

4. Reversible DC-to-DC power converter (10) according to Claim 1 or Claim 2, **characterized in that** said solder cap (18) includes a lower portion (28) having a flange (30) extending in the plane of said insulated metal substrate (4).

5. Reversible DC-to-DC power converter (10) according to Claim 1 or Claim 2, **characterized in that** said solder cap (18) includes a wall (27) having at least one fold (31).

6. Reversible DC-to-DC power converter (10) according to Claim 1 or Claim 2, **characterized in that** said solder cap (18) includes an upper portion (25) having a collar (37).

7. Method for manufacturing a reversible DC-to-DC power converter (1, 10) comprising SMC electronic components (5, 11, 13) that are mounted on an insulated metal substrate (4) and through-hole electronic elements (2, 3) including connection pins (20), said manufacturing method being suitable for manufacturing a power converter (10) according to any one of the preceding Claims 1 to 5, **characterized in that**:
- through-holes (32) are made in said insulated metal substrate (4) at sites that are intended to receive said connection pins (20);
- reflow soldering is used to solder said SMC electronic components (11, 13) to said insulated metal substrate (4) and solder caps (18) facing said through-holes (32);
- said electronic elements (2, 3) are placed under said insulated metal substrate (4) by inserting said connection pins (20) into said through-holes (32) and said solder caps (18);
- said solder caps (18) and said connection pins (20) are selectively wave-soldered.

8. Method for manufacturing a reversible DC-to-DC power converter (1, 10) comprising SMC electronic components (5, 11, 13) that are mounted on an insulated metal substrate (4) and through-hole electronic elements (2, 3) including connection lugs (34) or connection pins (33) having a domed end (36), said manufacturing method being suitable for manufacturing a power converter (10) according to any one of the preceding Claims 1 to 6, **characterized in that**:
- slots or through-holes (32) are made in said insulated metal substrate (4) at sites that are intended to receive said connection lugs (34) or said connection pins (33);
- reflow soldering is used to solder said SMC electronic components (11, 13) to said insulated metal substrate (4) and solder caps (18) having upper collars (37) facing said slots or said through-holes (32);
- said electronic elements (2, 3) are placed under said insulated metal substrate (4) by inserting said connection lugs (34) or said connection pins (33) into said slots or said through-holes (32) and said solder caps (18);
- said collars (34) and said connection lugs (34) or said connection pins (33) are electrically or laser-soldered.

9. Use of a reversible DC-to-DC power converter (10) according to any one of the preceding Claims 1 to 6 in a dual-voltage network of an automotive vehicle.
